(19) 

Europäisches
Patentamt

European
Patent Office

Office européen
des brevets

(11) **EP 2 663 171 A1**

(12) **EUROPEAN PATENT APPLICATION**

(43) Date of publication:
**13.11.2013 Bulletin 2013/46**

(51) Int Cl.:
***H05K 7/20*** (2006.01)

(21) Application number: **12003600.9**

(22) Date of filing: **07.05.2012**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Danfoss Drives A/S
6300 Graasten (DK)**

(72) Inventor: **Weiss, Dietmar
6200 Aabenraa (DK)**

(74) Representative: **Whiting, Gary
Danfoss A/S
Intellectual Property Department
L25
Nordborgvej 81
6430 Nordborg (DK)**

(54) **Dehumidifying method and arrangement**

(57) The present invention relates to a method for dehumidifying an enclosure adapted to accommodate electronics, the method comprising the steps of evaporating water or moisture formed within the enclosure at an essentially constant rate of evaporation, said essentially constant rate of evaporation being achieved by heating air within the enclosure in a manner so that the difference between saturation pressure and partial vapour pressure is kept essentially constant during evaporation. The invention further relates to an arrangement for carrying out the before-mentioned method.

Fig. 3

**Description**

FIELD OF THE INVENTION

The present invention relates to a method and a system for dehumidifying enclosures or cabinets adapted to house electronic equipment, such as power electronic equipment. In particular, the present invention relates to a method and a system facilitating evaporation of water or moisture formed in an enclosure followed by ventilation of the enclosure.

BACKGROUND OF THE INVENTION

Known systems for drying out enclosures containing electronic equipment typically involve one of the following techniques:

1. Condensation of water vapour at cold spots within the enclosure

2. Absorption of moisture by a desiccant

3. Cyclic heating of air or components in the enclosure

Condensation of water vapour (method 1) and desiccant-based solutions (method 2) require maintenance and have lower reliability compared to heating-based solutions (method 3). However, the known heating-based solutions exhibit a limited drying capability due to a low air exchange rate between air within the enclosure and air from the exterior of the enclosure (up to 10% of free enclosure volume).
It may be seen as an object of embodiments of the present invention to provide a high capacity method and associated arrangement for drying out enclosures of power electronic equipment so as to avoid corrosion of such equipment.
It may be seen as a further object of embodiments of the present invention to provide a method and an arrangement for maintaining the humidity within enclosures at corrosion preventing levels when the power electronic equipment is not in use.

DESCRIPTION OF THE INVENTION

The above-mentioned objects are complied with by providing, in a first aspect, a method for dehumidifying an enclosure adapted to accommodate electronics, the method comprising the steps of evaporating water or moisture formed within the enclosure at an essentially constant rate of evaporation, said essentially constant rate of evaporation being achieved by heating air within the enclosure in a manner so that the difference between saturation pressure and partial vapour pressure is kept essentially constant during evaporation.
The method of the present invention may be used for drying out an enclosure or it may be applied for keeping the humidity of the enclosure at a corrosion preventing level in order to increase the life time of electronic equipment positioned within the enclosure.
It is an advantage of the present invention that it ensures higher drying rates and reduced energy consumption during operation.
The heating of air within the enclosure may be followed by a step of ventilating the enclosure by replacing humid air containing the evaporated water or moisture with air from an exterior of the enclosure. Thus, if the controlled heating is followed by controlled/forced convection a more effective drying process can be achieved.
The step of ventilating the enclosure may be performed by generating a flow of air through at least part of the enclosure. The at least part of the enclosure may include an upper region of the enclosure where heated humid air tends to be located.
The step of evaporating water or moisture may be performed by increasing the temperature within at least part of the enclosure. The temperature may be increased to a predetermined temperature level. The temperature may be increased in a continuously manner or it may be increased in steps in accordance with a predetermined temperature profile.
The predetermined temperature level may be reached by applying electrical power to a heating element positioned within the enclosure. The electrical power may be applied to the heating element in a continuous manner, or it may be applied to the heating element in a cyclic manner.
The flow of air may be generated by activating a fan forming part of the enclosure. The fan may be intended to draw heated humid air to the exterior of the enclosure via a pipe being positioned within the enclosure.
In a second aspect the present invention relates to an arrangement for dehumidifying an enclosure adapted to accommodate electronics, the arrangement comprising means for evaporating water or moisture formed within the enclosure at an essentially constant rate of evaporation by ensuring that the difference between saturation pressure and partial vapour pressure is kept essentially constant during evaporation.

Moreover, means for ventilating the enclosure by replacing humid air containing the evaporated water or moisture with air from an exterior of the enclosure may be provided.

Similar to the first aspect the means for evaporating water or moisture may comprise a heating element, said heating element being operable in a continuous and/or a cyclic mode of operation. The heating element may be positioned within the enclosure.

The means for ventilating the enclosure may comprise controllable fan. The fan may be configured to draw heated humid air from an upper region of the enclosure to the exterior of the enclosure via a pipe. The controllable fan may form part of the enclosure itself.

In a third aspect the present invention relates to a method for dehumidifying an enclosure adapted to accommodate electronics, the method comprising the steps of

- generating humid air within the enclosure, and

- ventilating the enclosure by replacing humid air containing evaporated water or moisture with air from an exterior of the enclosure.

The humid air may be generated by a heating element as disclosed in connection with the first aspect of the present invention. The ventilation process may be performed as disclosed above.

In a fourth aspect the present invention relates to an arrangement for dehumidifying an enclosure adapted to accommodate electronics, the arrangement comprising

- means for generating humid air within the enclosure, and

- means for ventilating the enclosure by replacing humid air containing evaporated water or moisture with air from an exterior of the enclosure.

Again, the humid air may be generated by a heating element as disclosed in connection with the second aspect of the present invention. The ventilation means may be implemented as disclosed above.

In a fifth and final aspect the present invention relates to a power electronic device comprising an arrangement for dehumidifying an enclosure encapsulating the device, the arrangement comprising means for evaporating water or moisture formed within the enclosure at an essentially constant rate of evaporation by ensuring that the difference between saturation pressure and partial vapour pressure is kept essentially constant during evaporation. Means for ventilating the enclosure by replacing humid air containing evaporated water or moisture with air from an exterior of the enclosure may be provided as well. The power electronic device may comprise electronic equipment such motors, generators, inverters, converters etc.

The generation of humid air (evaporation process) may be generated by a heating element as disclosed in connection with the second aspect of the present invention. The ventilation means may be implemented using a fan and a pipe as previously disclosed.

BRIEF DESCRIPTION OF THE DRAWINGS

The present invention will now be explained in further details with reference to the accompanying figures, where

Fig. 1 illustrates how water or moisture is evaporated and subsequently removed from an enclosure,

Fig. 2 illustrates a Mollier diagram showing temperature vs. water content, and

Fig. 3 shows a dehumidification control algorithm.

While the invention is susceptible to various modifications and alternative forms, specific embodiments have been shown by way of examples in the drawings and will be described in detail herein. It should be understood, however, that the invention is not intended to be limited to the particular forms disclosed. Rather, the invention is to cover all modifications, equivalents, and alternatives falling within the spirit and scope of the invention as defined by the appended claims.

DETAILED DESCRIPTION OF THE INVENION

In its most general aspect the present invention relates to controlled drying out of enclosures, in particular enclosures adapted to house electronic equipment, such as power electronics. The present invention relates to controlled heating of such enclosures. The controlled heating can be followed by controlled replacement of humid air by applying controlled convection to certain regions of the enclosure. The solution offered by the present invention ensures larger drying rates and reduced energy consumption when air within such enclosures should be kept at corrosion preventing levels to avoid damages the electronic equipment.

Corrosion of electronic equipment is significantly determined by voltage differentials, conductive residue on printed circuit boards, and moisture within enclosures. The latter can be positively influenced by controlled dehumidification of enclosures. Dehumidification is a mass transfer process exploiting the specific thermo-physical properties of humid air.

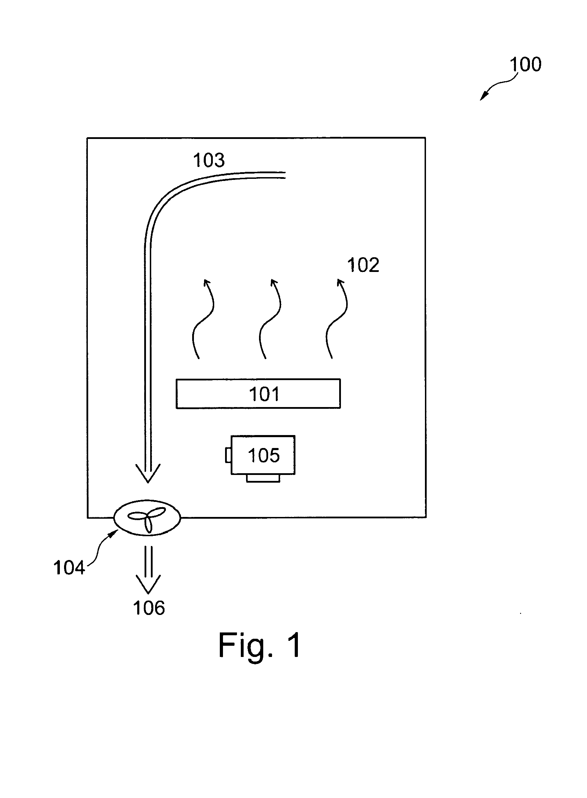

The method and the associated arrangement according to the present invention are depicted in Fig. 1, where the interior air of the enclosure 100 housing electronic equipment 105 is heated by heating element 101. The heated humid air 102 moves to the top of the enclosure 100. A fan 104 ventilates the enclosure 100 by controlled convection by replacing the heated humid air (having a high absolute humidity) with air from the exterior (having a lower absolute humidity) of the enclosure 100. The controlled convection is performed through pipe 103 which draws heated humid air to the exterior 106 of the enclosure 100. In this way the electronic equipment 105 can be kept free of corrosion.

The above-mentioned process can be performed in a continuous and/or in a cyclic manner, i.e. both the heating and the convection process may be performed in a continuous and/or in a cyclic manner.

The evaporation process is driven by the difference between the saturation pressure $p_{Ssat}$ of the humid air (dependent on temperature $T$) and its partial vapor pressure $p_{vap}$ (dependent on water content x).

Heating of the air within the enclosure reduces the relative humidity and increases the saturation pressure of the air. Consequently, the evaporation rate

$$\dot{m}_{evap}$$

increases with rising temperature in accordance with Dalton's law of evaporation:

$$\dot{m}_{evap} \; = \; \beta \left| \, p_{sat}(T) - p_{vap}(x) \, \right| A_{evap}$$

where $\beta$ is the mass transfer coefficient and $A_{evap}$ is the evaporation area.

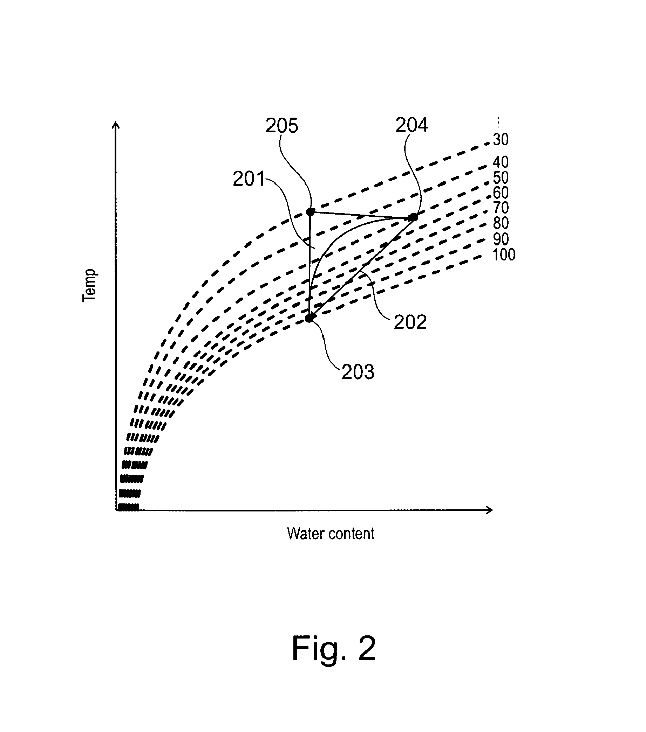

A typical evaporation process is illustrated in Fig. 2 where the curve 201 (from point 203 to point 204) indicates the increase in temperature and relative humidity.

Ventilating the enclosure after the evaporation phase reduces the water content by replacing heated humid air having high absolute humidity with cold air with lower absolute humidity, cf. curve 202 (from point 204 to point 203). The various dotted curves represent different humidity levels ranging from 30% humidity (highest curve) to 100% humidity (lowest curve).

In contrast, a dehumidification process without air exchange could be represented as a state change with x (water content) being constant. In an ideal situation this corresponds to moving from working point 203 to working point 205, cf. Fig. 2. Obviously, such state change with x (water content) being constant does not change the absolute humidity within the enclosure.

The controlled convection may be implemented using a pipe 103 in combination with a fan 104, cf. Fig. 1. The upper end of the pipe is located at the position in the enclosure where the highest humidity is expected, typically at or near an upper region of the enclosure.

As previously mentioned the heating and the convection process may be performed in a continuous and/or in a cyclic manner. A cyclic heating and convection process is controlled by the difference between absolute humidity inside and outside the enclosure. Exemplarily values of such a cyclic process may be as follows in case of an enclosure having a free air volume of around 35 liters:

1. Total cycle period: 30 minutes

2. Heating time: 20 minutes

3. Air exchange time: 1-2 minutes - typically an air volume of 150% of the enclosure volume is exchanged ( 2 cm pipe diameter)

An estimated power use of 50 W is required for each cycle.

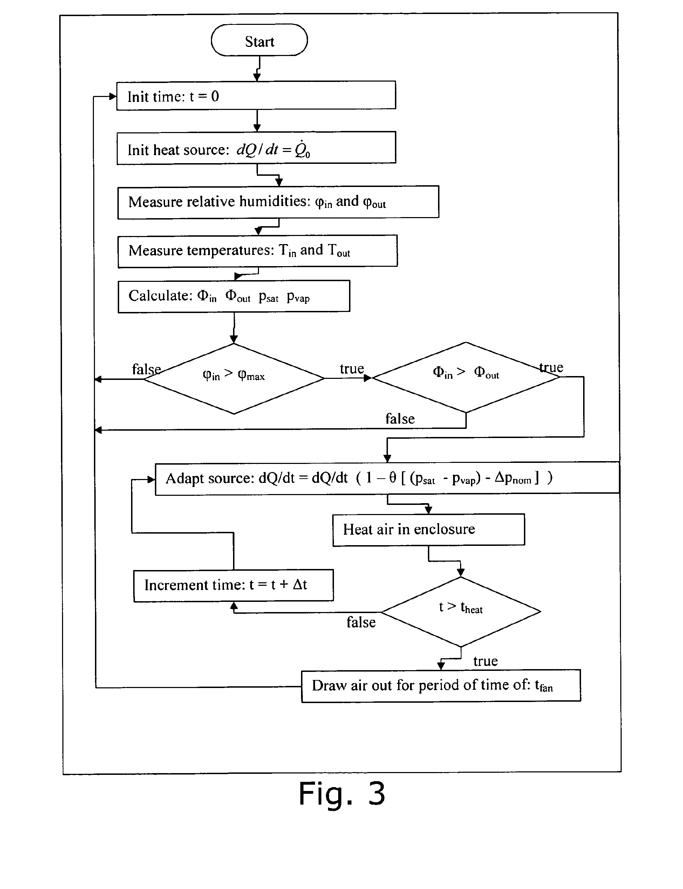

A cyclic heating and convection process can be controlled as illustrated in the flowchart shown in Fig. 3 - the following process steps should be considered:

1. Sensors measure the relative humidity inside and outside the enclosure and the inside and outside temperature.

2. From the above data the absolute humidity $\Phi$ inside ($\Phi_{in}$) and outside ($\Phi_{out}$) the enclosure, the saturation pressure ($p_{sat}$) and the partial vapour pressure ($p_{vap}$) are calculated.

3. Heating and air exchange will be only performed if the relative humidity $\varphi_{in}$ in the enclosure is greater than a given threshold (e.g. $\varphi_{max}$ = 60% RH) and the absolute humidity $\Phi_{in}$ inside is greater than the absolute humidity $\Phi_{out}$ outside the enclosure.

4. The heat flux during the heating interval is adapted in a way that the difference between saturation pressure and partial vapour pressure is kept constant. $\Theta$ is a relaxation factor for calculating the adapted heat flux and $\Delta p_{nom}$ is the nominal pressure difference. The length of the heating interval is predefined.

5. After reaching the end of the heating interval the air in the enclosure is drawn out by a fan with a constant volume flux. The length of the air exchange interval ensures that a volume of air corresponding to 150% of the free air volume in the enclosure will flow out of the enclosure.

6. Optionally repeating steps 1) - 4) in a predetermined pattern

As previously mentioned the period of a cycle can be 30 minutes. However, other period lengths (shorter or longer) may be applicable as well.

In general, cyclic heating and convection processes are typically applied when the humidity of an enclosure is to be kept at non-corrosion levels.

In contrast to cyclic heating and convection continuous heating and convection may be applied. In this approach heating and controlled convection are operated in a continuous manner.

**Claims**

1. A method for dehumidifying an enclosure adapted to accommodate electronics, the method comprising the steps of evaporating water or moisture formed within the enclosure at an essentially constant rate of evaporation, said essentially constant rate of evaporation being achieved by heating air within the enclosure in a manner so that the difference between saturation pressure and partial vapour pressure is kept essentially constant during evaporation.

2. A method according to claim 1, further comprising the step of ventilating the enclosure by replacing humid air containing the evaporated water or moisture with air from an exterior of the enclosure.

3. A method according to claim 2, wherein the step of ventilating the enclosure is performed by generating a flow of air through at least part of the enclosure.

4. A method according to any of claims 1-3, wherein the step of evaporating water or moisture is performed by increasing the temperature within at least part of the enclosure to a predetermined temperature level.

5. A method according to claim 4, wherein the predetermined temperature level is reached by applying electrical power to a heating element positioned within the enclosure.

6. A method according to claim 5, wherein electrical power is applied to the heating element in a continuous manner.

7. A method according to claim 5, wherein electrical power is applied to the heating element in a cyclic manner.

**8.** A method according to claim 2, wherein the flow of air is generated by activating a fan forming part of the enclosure.

**9.** An arrangement for dehumidifying an enclosure adapted to accommodate electronics, the arrangement comprising means for evaporating water or moisture formed within the enclosure at an essentially constant rate of evaporation by ensuring that the difference between saturation pressure and partial vapour pressure is kept essentially constant during evaporation.

**10.** An arrangement according to claim 9, further comprising means for ventilating the enclosure by replacing humid air containing the evaporated water or moisture with air from an exterior of the enclosure.

**11.** An arrangement according to claim 9 or 10, wherein the means for evaporating water or moisture comprises a heating element.

**12.** An arrangement according to claim 11, wherein the heating element is positioned within the enclosure.

**13.** An arrangement according to any of claims 9-12, wherein the means for ventilating the enclosure comprises a controllable fan.

**14.** An arrangement according to claim 13, wherein the controllable fan forms part of the enclosure.

**15.** A power electronic device comprising an arrangement for dehumidifying an enclosure encapsulating the device, the arrangement comprising means for evaporating water or moisture formed within the enclosure at an essentially constant rate of evaporation by ensuring that the difference between saturation pressure and partial vapour pressure is kept essentially constant during evaporation.

Fig. 1

Fig. 2

Fig. 3

Europäisches
Patentamt

European
Patent Office

Office européen
des brevets

**EUROPEAN SEARCH REPORT**

Application Number

EP 12 00 3600

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 105 875 A (LAGROTTA JAMES T [US] ET AL) 22 August 2000 (2000-08-22)<br>* the whole document *<br>----- | 1,9 | INV.<br>H05K7/20 |
| A | US 5 934 368 A (TANAKA TETSUYA [JP] ET AL) 10 August 1999 (1999-08-10)<br>* the whole document *<br>----- | 1,9 | |
| A | "Psychrometric Chart Structure and Application",<br>,<br>1 August 2007 (2007-08-01), XP55051670,<br>Retrieved from the Internet:<br>URL:https://www.hqs.sbt.siemens.com/gip/general/dlc/data/assets/hq/Structure-and-Application-Structure-and-Application_8313_hq-en.pdf<br>[retrieved on 2013-01-30]<br>* the whole document *<br>----- | 1,9 | |
| | | | TECHNICAL FIELDS SEARCHED (IPC) |
| | | | H05K |

The present search report has been drawn up for all claims

| Place of search | Date of completion of the search | Examiner |
|---|---|---|
| The Hague | 30 January 2013 | Toussaint, François |

EPO FORM 1503 03.82 (P04C01)

EP 2 663 171 A1

## ANNEX TO THE EUROPEAN SEARCH REPORT
## ON EUROPEAN PATENT APPLICATION NO.

EP 12 00 3600

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2013

| Patent document cited in search report | | Publication date | Patent family member(s) | | Publication date |
|---|---|---|---|---|---|
| US 6105875 | A | 22-08-2000 | NONE | | |
| US 5934368 | A | 10-08-1999 | JP | 3232908 B2 | 26-11-2001 |
| | | | JP | 8088493 A | 02-04-1996 |
| | | | US | 5934368 A | 10-08-1999 |

EPO FORM P0459